# EUROPÄISCHE PATENTSCHRIFT

(11) **EP 4 602 379 B1**
(45) Veröffentlichungstag und Bekanntmachung des Hinweises auf die Patenterteilung: **02.12.2026**
(21) Anmeldenummer: 23789276.5
(22) Anmeldetag: 09.10.2023
(51) Int. Cl.: G01R 27/02

(54) **VERFAHREN ZUR IMPEDANZMESSUNG ELEKTRISCHER BAUELEMENTE**
METHOD FOR MEASURING THE IMPEDANCE OF ELECTRICAL COMPONENTS
PROCÉDÉ POUR LA MESURE DE L'IMPÉDANCE DE COMPOSANTS ÉLECTRIQUES

(30) Priorität: 10.10.2022 DE 102022126107
(43) Veröffentlichungstag der Anmeldung: 20.08.2025
(73) Patentinhaber: Elmos Semiconductor SE, 51379 Leverkusen (DE)
(72) Erfinder: MELCHER, Rolf, 51645 Gummersbach (DE); FRANK, Thomas, 76676 Graben-Neudorf (DE)
(74) Vertreter: dompatent
(86) Internationale Anmeldenummer: PCT/EP2023/077898
(87) Internationale Veröffentlichungsnummer: WO 2024/079047

(56) Entgegenhaltungen:
- US-A1- 2019 250 298
- US-A1- 2022 206 076
- US-A1- 2022 300 111
- US-B2- 7 555 394

## Beschreibung

Die Erfindung betrifft ein Verfahren zur Messung der Impedanz elektrischer Bauteile und insbesondere ein Verfahren zur in mehreren Intervallen und damit wiederholt erfolgenden Ermittlung eines für die Größe und/oder die Veränderung einer Impedanz charakteristischen elektrischen Signals, wobei sich die Impedanz z.B. unter dem Einfluss eines magnetischen, elektrischen und/oder elektromagnetischen Feldes ändern kann, das sich einerseits durch ein sich der Impedanz annäherndes Objekt verändern kann.

Je nach Anwendungsfall ist die wiederholte Ermittlung der Impedanz von in einem Fahrzeug verbauten elektrischen Bauteilen von großer Bedeutung. Hier sei beispielsweise auf die Erkennung des Erfassens des Lenkrades mit einer Hand des Fahrers oder aber die Sitzplatzbelegungserkennung genannt.

Durch verschiedene Einflussfaktoren oder aber auch Kompensationsmaßnahmen sind die Messsignale, die für die Impedanzmessung verwendet werden, nicht frei von Offsets. So führen beispielsweise extern beschaltete EMV-Filter zur Entstehung derartiger Offsets.

Der Offset-Signalanteil kann mitunter deutlich größer als der Nutzsignalanteil sein. Daher müssen bei einer digitalen Verarbeitung des Messsignals typischerweise Analog-Digital-Wandler (ADC) mit einer vergleichsweise hohen Auflösung und Bitanzahl sowie hoher zulässiger Eingangsspannung eingesetzt werden, was aber einen zu großen Aufwand bedeutet und insofern nachteilig ist. Ist die maximale Auflösung der verwendeten ADCs limitiert, so ist auch die Auflösung des Messsignals stark begrenzt, was bei vergleichsweise großen Signalen besonders nachteilig ist.

Aus US-A-2021/0081073 ist ein Verfahren zur Impedanzmessung elektrischer Bauteile bekannt. Gemäß diesem Verfahren wird das Messsignal mit Hilfe eines Transimpedanzverstärkers verstärkt, was bedeutet, dass vergleichsweise große Messsignale verarbeitet werden. Das aber birgt die Gefahr, dass bei der Digital-Verarbeitung des Messsignals die hierfür erforderlichen Analog-Digital-Wandler eine vergleichsweise hohe Auflösung und Bitanzahl sowie eine hohe zulässige Eingangsspannung aufweisen sollten, was mit dem bereits zuvor beschriebenen entsprechenden großen Aufwand verbunden ist.

In US-B-9 575 105 sind ein Verfahren und eine Vorrichtung zur Messung komplexer Impedanzen beschrieben.

Schließlich zeigt DE-A-10 2013 227 225 eine strombasierte Ladungskompensation in einem Berührungssensor, der kapazitiv arbeitet.

US 7 555 394 zeigt eine Messschaltung und ein Verfahren zur Bestimmung einer Impedanzcharakteristik eines komplexen Impedanzelementes zur Charakterisierung der Impedanz des Impedanzelementes.

Aufgabe der Erfindung ist es, ein Verfahren der eingangs genannten Art anzugeben, mit dem sich die die Impedanz repräsentierenden Signale gering halten lassen, ohne die Genauigkeit der Messung zu beeinträchtigen.

Zur Lösung dieser Aufgabe wird mit der Erfindung in einer ersten Variante ein Verfahren zur in mehreren Intervallen und damit wiederholt erfolgenden Ermittlung eines für die Größe und/oder die Veränderung einer Impedanz charakteristischen elektrischen Signals vorgeschlagen, die sich unter dem Einfluss eines magnetischen, elektrischen und/oder elektromagnetischen Feldes ändert, das sich seinerseits durch ein sich der Impedanz annäherndes Objekt verändert, wobei bei dem Verfahren
- die Intervalle mindestens eine Gruppe von Messintervallen, die ein Messintervall oder mehrere aufeinanderfolgende Messintervalle aufweist, und mindestens ein Kompensationsintervall umfassen, das oder die zeitlich vor der mindestens einen Gruppe oder vor jeder Gruppe von Messintervallen positioniert ist bzw. sind,
- pro Messintervall
   - die Impedanz mit einer sinusförmigen Anregungsspannung beaufschlagt wird und
   - in der Impedanz als Folge der Anregungsspannung ein Messstrom induziert wird,
- wobei der Messstrom eines Kompensationsintervalls als ein Kompensationsstrom für mindestens ein nachfolgendes Messintervall genutzt wird, indem der Kompensationsstrom in dem mindestens einen nachfolgenden Messintervall von dem Messstrom dieses Messintervalls zur Bildung eines analogen Auswertestromsignals subtrahiert wird, und
- das Auswertestromsignal das für die Größe und/oder die Veränderung der Impedanz charakteristische Signal ist.

Nach der Erfindung erfolgt die Ermittlung in Intervallen, die mindestens eine Gruppe von Messintervallen umfassen, wobei die Gruppe ein Messintervall oder mehrere aufeinanderfolgende Messintervalle und mindestens ein Kompensationsintervall aufweist, das oder die zeitlich vor der mindestens einen Gruppe oder vor jeder Gruppe von Messintervallen positioniert ist bzw. sind. In sämtlichen dieser Intervalle (Messintervalle und Kompensationsintervalle) wird ein Messstrom erfasst, der als Folge einer Anregungsspannung durch die Impedanz induziert wird, mit welcher diese sinusförmig angeregt wird. Der Messstrom eines Kompensationsintervalls wird als Kompensationsstrom in mindestens einem der nachfolgenden Messintervalle genutzt, indem er in dem mindestens einen nachfolgenden Messintervall von dem in diesem Messintervall erhaltenen Messstrom zur Bildung eines analogen Auswertestromsignals subtrahiert wird. Das Auswertestromsignal ist nun für die Größe und/oder die Veränderung der Impedanz charakteristisch.

Durch den erfindungsgemäßen Ansatz, von Intervall zu Intervall lediglich die Veränderungen der Impedanz zu erfassen, werden die elektrischen Stromsignale "klein" gehalten. Für die weitere Verarbeitung kann mit hoher Auflösung gearbeitet werden, und zwar auch dann, wenn beispielsweise zu Zwecken einer digitalen Signalverarbeitung mit ADCs gearbeitet wird, deren Auflösung (also deren Bitanzahl) und zulässiger Eingangsspannungsbereich begrenzt sind.

Nach der Erfindung ist es von Vorteil, wenn das analog vorliegende Auswertestromsignal verstärkt wird und dass das dergestalt verstärkte Auswertestromsignal das für die Größe und/oder die Veränderung der Impedanz charakteristische Signal ist. Auch hier ergeben sich keinerlei nennenswerte Einschränkungen bei einer Umsetzung des verstärkten analogen Auswertestromsignals in ein digitales Signal, wenn das verstärkte analoge Auswertestromsignal (noch) nicht zur Überschreitung des ADCs führt. Ggfs. kann der Verstärkungsfaktor des Verstärkers automatisch entsprechend dynamisch angepasst werden, so dass das verstärkte Signal unabhängig von der Größe des analogen Auswertestromsignals am Eingang des Verstärkers stets die zur Vermeidung einer Übersteuerung des ADCs erforderliche maximal zulässige Größe hat.

In weiterer vorteilhafter Ausgestaltung der Erfindung kann vorgesehen sein, dass der Kompensationsstrom nach seiner Ermittlung von einer Signalerzeugungseinheit erzeugt wird, um von dem Messstrom des mindestens einen Messintervalls subtrahiert zu werden.

Die Platzierung von Kompensationsintervallen zwischen den und innerhalb der Gruppen von Messintervallen kann vielfältig erfolgen. So könnte man beispielsweise zu Beginn des Verfahrens ein (einziges) Kompensationsintervall vorsehen, das für die nachfolgenden Messintervalle denjenigen Kompensationsstrom liefert, der stets vom jeweiligen danach in jedem Messintervall gemessenen Messstrom subtrahiert wird. Ist allerdings zu befürchten, dass der Kompensationsstrom im Laufe der intermittierenden Impedanzmessung nicht mehr gut genug angepasst ist, um nach Subtraktion vom jeweiligen Messstrom noch zu einem ausreichend kleinen analogen Auswertestromsignal zu führen, so ist es von Vorteil, wenn man ab Überschreitung der Aus- bzw. Übersteuerungsgrenze des ADCs erneut ein Kompensationsintervall durchführt, um für die nächsten Messintervalle wiederum ein vergleichsweise kleines analoges Auswertestromsignal zu erhalten. Wird das Auswertestromsignal vor der Analog-Digital-Wandlung verstärkt, was typischerweise der Fall ist, so könnte die Bedingung für eine erneute Bestimmung des Kompensationsstroms das Überschreiten einer vorgegebenen maximal zulässigen Größe des Auswertestromsignals am Eingang des Verstärkers oder bei Verwendung eines Verstärkers mit sich automatisch an die Größe des Eingangssignals anpassendem Verstärkungsfaktor die Unterschreitung eines vorgegebenen minimal zulässigen Verstärkungsfaktors sein.

Wie bereits oben erwähnt, ist das Ziel der Erfindung, mit vergleichsweise kleinen analogen Auswertestromsignalen weiterarbeiten zu können, um nämlich dann nach typischerweise erfolgter Verstärkung mit in ihrer Auflösung und ihrer maximal zulässigen analogen Eingangsspannung begrenzten ADCs und mit dennoch ausreichend hoher Auflösung weiterarbeiten zu können, sofern die weitere Signalverarbeitung digital erfolgt, worauf weiter unten noch eingegangen werden wird.

In weiterer vorteilhafter Ausgestaltung der Erfindung kann es von Vorteil sein, wenn das gegebenenfalls verstärkte analoge Auswertestromsignal nach einer Analog-Digital-Konvertierung einer I-Q-Demodulation unterzogen wird, wobei der I-Signalanteil und/oder der Q-Signalanteil der I-Q-Demodulation das für die Größe und/oder die Veränderung der Impedanz charakteristische Signal ist. Bei dieser Ausgestaltung der Erfindung wird von einer digitalen I-Q-Demodulation Gebrauch gemacht, deren I- und Q-Amplituden die für die Größe und/oder die Veränderung der Impedanz charakteristischen Werte liefern. Bei dieser Weiterbildung der Erfindung kann nun der Kompensationsstrom erzeugt werden, und zwar anhand der Parameter der digitalen I-Q-Demodulation des zeitlich letzten Kompensationsintervalls. Hier erfolgt also die Kompensationsstromerzeugung ebenfalls digital, woraufhin dann der so erzeugte Kompensationsstrom durch einen Digital-Analog-Wandler (DAC) in einen analogen Kompensationsstrom umgewandelt wird, der dann vom Messstrom des jeweiligen Messintervalls subtrahiert wird.

Die digitale Signalverarbeitung in Form der digitalen I-Q-Demodulation bietet eine Vielzahl von Vorteilen. Allerdings ist die bei der digitalen Verarbeitung der Signale maximal erreichbare Auflösung auf Grund der endlichen Eingangsspannung des ADC begrenzt. Vergrößert also beispielsweise ein Offset die Messwerte, so verringert sich die maximal erreichbare Auflösung dementsprechend. Daher sollte man Ströme, welche durch parallel zu der zu messenden veränderlichen Impedanz geschaltet sind, kompensieren. Dies erfolgt erfindungsgemäß durch die Subtraktion der Kompensationsströme von den eigentlichen Messströmen, so dass die analogen Auswertestromsignale möglichst klein sind. Dann erhält man nach einer ggfs. erfolgenden Signalverstärkung trotz limitierter Auflösung des ADCs eine hohe Auflösung des Messwerts für die digitale Signalverarbeitung. Die Amplitude des analogen Auswertestroms kann dann also sogar noch verstärkt werden, bevor die Verarbeitung im ADC erfolgt. Für sinusförmige Anregungssignale, die im Rahmen der Erfindung vorteilhafterweise verwendet werden, kann das Offsetsignal als Summe der skalierten I-Q-Demodulationssignale erzeugt werden und beispielsweise mit Hilfe eines Strom-DACs für die Subtraktion zurückgespeist werden.

Bei Verwendung einer analogen Demodulation lässt sich die erreichbare Signalauflösung erhöhen, indem nach der Demodulation ein DC-Offset subtrahiert wird und das Signal anschließend verstärkt werden kann, bevor es in einen ADC eingespeist wird. Bei einer digitalen Demodulation, wie dies in vorteilhafter Weiterbildung der Erfindung vorgesehen ist, ist dies nicht möglich, da am ADC ein Wechselsignal anliegt und dieses Signal nicht mit einem DC-Offset kompensiert werden kann.

Durch das erfindungsgemäße Kompensationsverfahren mit vorteilhafterweise vorzusehender digitaler Demodulation kann das Auswertestromsignal höher verstärkt werden, ohne dass der (begrenzte) Eingangsspannungsbereich des ADCs überschritten wird. Dadurch ist wie bei der analogen Demodulation eine Erhöhung der Auflösung möglich.

Gemäß einer Variante der oben genannten Lösung der Aufgabe wird ein Verfahren zur in mehreren Intervallen und damit wiederholt erfolgenden Ermittlung eines für die Größe und/oder die Veränderung einer Impedanz charakteristischen elektrischen Signals vorgeschlagen, die sich unter dem Einfluss eines magnetischen, elektrischen und/oder elektromagnetischen Feldes ändert, das sich seinerseits durch ein sich der Impedanz annäherndes Objekt verändert, wobei bei dem Verfahren
- pro Intervall
   - die Impedanz mit einer sinusförmigen Anregungsspannung beaufschlagt wird und
   - in der Impedanz als Folge der Anregungsspannung ein Messstrom induziert wird,
- die Differenz aus dem Messstrom und einem Kompensationsstrom dem Eingang eines analogen oder digitalen Integrators zugeführt wird, dessen Ausgangs ggfs. nach einer Digital-Analog-Konvertierung den Kompensationsstrom liefert, und
- der Ausgang des Integrators (42) das für die Größe und/oder Veränderung der Impedanz charakteristische Signal bildet.

Bei dieser zweiten Variante der Erfindung wird ein rückgekoppeltes System zur Bildung des Kompensationsstroms verwendet, der von dem Messstrom subtrahiert wird. Jedes Intervall ist also insoweit ein Messintervall im oben genannten Sinne der ersten Variante der Erfindung. Durch einen Fehler- oder Delta-Integrator, der auf Veränderungen des Messsignals reagiert, wird die Differenz aus Kompensationsstrom und Messstrom aufintegriert. Im stationären Fall liefert dann der Delta-Integrator an seinem Ausgang ein konstantes Signal, was angibt, dass sich die Impedanz nicht verändert. Verändert sie sich, so entsteht am Ausgang des Integrators eine Veränderung seines Signals, was dann wiederum rückgekoppelt wird als veränderter Kompensationsstrom und somit auch die Veränderung der Impedanz aufzeigt.

Auch bei dieser zweiten Variante der Erfindung wird also mit kleinstmöglichen Signalen gearbeitet, was wiederum den bereits zuvor genannten Vorteil mit sich bringt, dass nämlich zur Umsetzung der analogen Messsignale in digitale Signale mit herkömmlichen ADCs begrenzte Auflösung und limitierter zulässiger Eingangsspannungsbereich gearbeitet werden kann (,wobei diese kleinen analogen Messsignale dann noch verstärkt werden können), ohne dass auf die für die Auswertung der Messströme gewünschte hohe Auflösung verzichtet werden muss.

In weiterer vorteilhafter Ausgestaltung der Erfindung gemäß ihrer zweiten Variante kann vorgesehen sein, dass das Differenzsignal aus der Differenz von Messstrom und Kompensationsstrom, gegebenenfalls nach einer Verstärkung, einer Analog-Digital-Konvertierung unterzogen und anschließend einem digitalen I-Q-Demodulator zugeführt wird, dessen I- und Q-Signalanteile dem Eingang eines digitalen Integrators zugeführt werden, und dass zur Bildung des Kompensationsstroms die über die Zeit integrierten I- und Q-Signalanteile in einem digitalen I-Q-Modulator moduliert werden, dessen Ausgang mit einem Digital-Analog-Konverter verbunden ist, der den Kompensationsstrom ausgibt.

Die oben genannte Aufgabe wird gemäß einer dritten Variante der Erfindung gelöst durch ein Verfahren zur in mehreren Intervallen und damit wiederholt erfolgenden Ermittlung eines für die Größe und/oder die Veränderung einer Impedanz charakteristischen elektrischen Signals, die sich unter dem Einfluss eines magnetischen, elektrischen und/oder elektromagnetischen Feldes ändert, das sich seinerseits durch ein sich der Impedanz annäherndes Objekt verändert, wobei bei dem Verfahren
- pro Intervall
   - die Impedanz mit einer sinusförmigen Anregungsspannung beaufschlagt wird,
   - in der Impedanz als Folge der Anregungsspannung ein Messstrom induziert wird,
   - eine Referenzimpedanz bekannter Größe mit einer zur Anregungsspannung um 180° phasenverschobenen Kompensationsspannung beaufschlagt wird und
   - in der Referenzimpedanz als Folge der Kompensationsspannung ein Kompensationsstrom induziert wird,
- die Differenz aus dem Messstrom und dem Kompensationsstrom dem Eingang eines analogen oder digitalen Integrators zugeführt wird, dessen Ausgang ggfs. nach einer Digital-Analog-Konvertierung die Größe der Kompensationsspannung liefert,
- die Kompensationsspannung erzeugt wird und
- der Ausgang des Integrators (42) das für die Größe und/oder die Veränderung der Impedanz charakteristische Signal ist.

Bei dieser dritten Variante der Erfindung wird zur Ermittlung der Größe der Impedanz mit einer Referenzimpedanz gearbeitet. Die Referenzimpedanz wird mit einer Kompensationsspannung angeregt und induziert daraufhin einen Kompensationsstrom, der von dem Messstrom, der infolge der Anregungsspannung für die zu vermessende Impedanz induziert wird, subtrahiert wird.

Das Differenzsignal wird einem digitalen Delta-Integrator zugeführt, der die Differenz aufintegriert und an seinem Ausgang die Kompensationsspannung bestimmt, die wiederum für die Anregung der Referenzimpedanz genutzt wird. Die Größe der Kompensationsspannung ist charakteristisch für die Größe der Impedanz und/oder deren Veränderung.

Statt einer Referenzimpedanz können auch mehrere unterschiedlich große Referenzimpedanzen gewählt werden, und zwar in Abhängigkeit von der Größe der zu vermessenden Impedanz. Auf diese Weise ist das Differenzsignal minimal, was wiederum zu den oben angegebenen Vorteilen hinsichtlich der hohen Auflösung im Digitalteil trotz limitierter Bitanzahl und Eingangsspannung des ADCs führt.

Die unterschiedlichen Referenzimpedanzen können wahlweise über einen Multiplexer angesteuert werden. Alternativ kann aber auch die Referenzimpedanz hinsichtlich ihrer Größe verstellt werden. Hier bietet sich zusätzlich der Einsatz einer überlagerten Regelschleife an mit dem Ziel einer Normierung des Messergebnisses auf 1.

In weiterer vorteilhafter Ausgestaltung der Erfindung kann vorgesehen sein, dass das Differenzsignal aus der Differenz von Messstrom und Kompensationsstrom, ggfs. nach einer Verstärkung, einer Analog-Digital-Konvertierung unterzogen und anschließend einem digitalen I-Q-Demodulator zugeführt wird, dessen I- und Q-Signalanteile dem Eingang eines digitalen Integrators zugeführt werden, und dass zur Bildung der Kompensationsspannung die über die Zeit integrierten I- und Q-Signalanteile in einem digitalen I-Q-Modulator moduliert werden, dessen Ausgang mit einem Digital-Analog-Konverter verbunden ist, der die Kompensationsspannung ausgibt.

Bei der zu vermessenden Impedanz handelt es sich insbesondere um einen kapazitiv arbeiteten Sitzplatzbelegungssensor, dessen Elektroden sich unter der Einwirkung von Gewicht einander annähern und somit für eine Kapazitätsänderung sorgen (siehe z.B. US 8 896 326 B2, in der auch das Auswerteprinzip zur Ermittlung der Größe der Impedanz anhand einer I-Q-Demodulation, wie es auch nach der Erfindung vorteilhaft eingesetzt wird, beschrieben ist). Ein weiterer Anwendungsbereich des erfindungsgemäßen Verfahrens ist die Erkennung, ob der Fahrer das Lenkrad ergreift. Hierzu sind im Lenkrad einzelne Elektrodenflächen angeordnet, die zusammen mit dem Fahrzeug-Chassis einen Kondensator bilden, dessen Dielektrikum durch die Hand beeinflusst wird, woraus eine Kapazitätsänderung hervorgeht.

Die oben genannte Aufgabe wird gemäß einer vierten Variante der Erfindung durch ein Verfahren laut dem Anspruch 15 gelöst.

Die Erfindung wird nachfolgend anhand verschiedener Ausführungsbeispiele und unter Bezugnahme auf die Zeichnung näher erläutert. Im Einzelnen zeigen dabei:
- Fig. 1: ein Blockschaltbild eines ersten Ausführungsbeispiels für eine Schaltung zur Impedanzmessung,
- Fig. 2: ein Blockschaltbild eines zweiten Ausführungsbeispiels für eine Schaltung zur Impedanzmessung,
- Fig. 3: ein Blockschaltbild eines dritten Ausführungsbeispiels für eine Schaltung zur Impedanzmessung,
- Fig. 4: ein Blockschaltbild eines vierten Ausführungsbeispiels für eine Schaltung zur Impedanzmessung,
- Fig. 5: ein Blockschaltbild eines fünften Ausführungsbeispiels für eine Schaltung zur Impedanzmessung und
- Fig. 6: ein Blockschaltbild eines sechsten Ausführungsbeispiels für eine Schaltung zur Impedanzmessung.

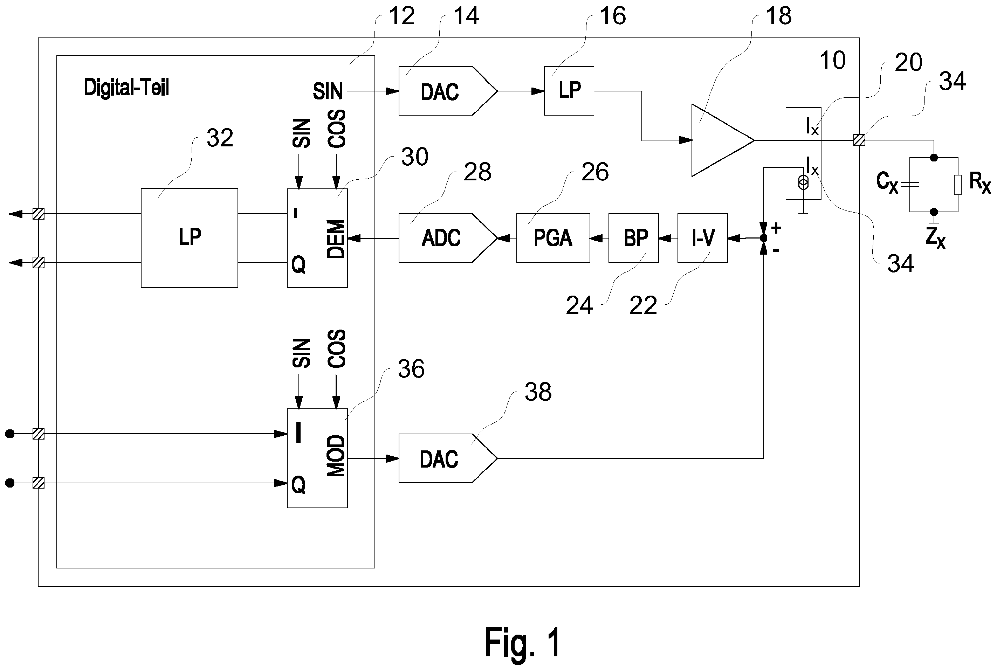

Fig. 1 zeigt das Blockschaltbild einer Schaltung 10 eines ersten Ausführungsbeispiels der Erfindung. Eine zu vermessende Impedanz Z_{X} wird mittels eines Sinusspannungssignals angeregt, das in einem Digital-Teil 12 der Schaltung 10 erzeugt wird. Vermittels eines DAC 14 wird das digitale Sinussignal in ein **analoges** Sinussignal gewandelt und nach einer Tiefpassfilterung in einem Tiefpassfilter 16 von einem Treiber 18 der zu vermessenen Impedanz Z_{X} zugeleitet. Als Reaktion darauf wird in der Impedanz Z_{X} ein Strom I_{X} induziert, der in einem Stromspiegel 20 gespiegelt wird. Der gespiegelte Strom I_{X} wird nach einer Strom-Spannungs-Wandlung in einem I-V-Wandler 22 (beispielsweise Shunt-Widerstand) und einer Bandpassfilterung in einem Bandpassfilter 24 einem Verstärker 26 zugeführt, dessen Ausgangssignal mittels eines ADC 28 in ein Digital-Signal zur Verarbeitung im Digital-Teil 12 gewandelt wird. Im Digital-Teil 12 erfolgt eine I-Q-Demodulation in einem I-Q-Demodulator 30 zur Ermittlung des Real-Teils und des Imaginär-Teils des komplexen induzierten Stroms I_{X}. Nach einer weiteren Filterung in einem Digitalfilter 32 liegen dann zwei Signale vor, die repräsentativ sind für die Größe der Impedanz Z_{X} und z.B. extern der Schaltung 10 weiterverarbeitet werden können.

Auf Grund von Störunterdrückungsmaßnahmen für beispielsweise einen EMV-Schutz ist der Eingang 34 der typischerweise integrierten Schaltung 10, an den die zu vermessende Impedanz Z_{X} angeschlossen ist, mit im Verhältnis zur zu vermessenden Impedanz Z_{X} vergleichsweise großen Kapazität beschaltet. Hierdurch entstehen Offsets im Messsignal, die kompensiert werden sollten, um mit vergleichsweise einfachen Mitteln hochauflösend messen zu können. Daher wird von dem gespiegelten Strom I_{X} ein Kompensationsstrom subtrahiert, der den Offset somit kompensiert. Als Ergebnis dieser Kompensation verbleiben sehr kleine Signale, die nach einer Verstärkung mit einem ADC 28 mit limitierter Bitanzahl und begrenzter Eingangsspannung immer noch ausreichend hochaufgelöst in ein Digital-Signal umgesetzt und im Digital-Teil 12 weiterverarbeitet werden können. Der Kompensationsstrom wird im Digital-Teil 12 erzeugt und einer I-Q-Modulation in einem I-Q-Modulator 36 unterzogen und anschließend durch einen DAC 38 in den analogen Kompensationsstrom umgewandelt.

Die Schaltung 10 arbeitet intermittierend und in Intervallen. Der in einem dieser Intervalle ermittelte Messwert für den gemessenen Strom im Digital-Teil 12 kann dazu genutzt werden, um mit den Parametern des I-Q-Demodulators 30 den I-Q-Modulator 36 für die Erzeugung des digitalen Kompensationsstroms zu betreiben.

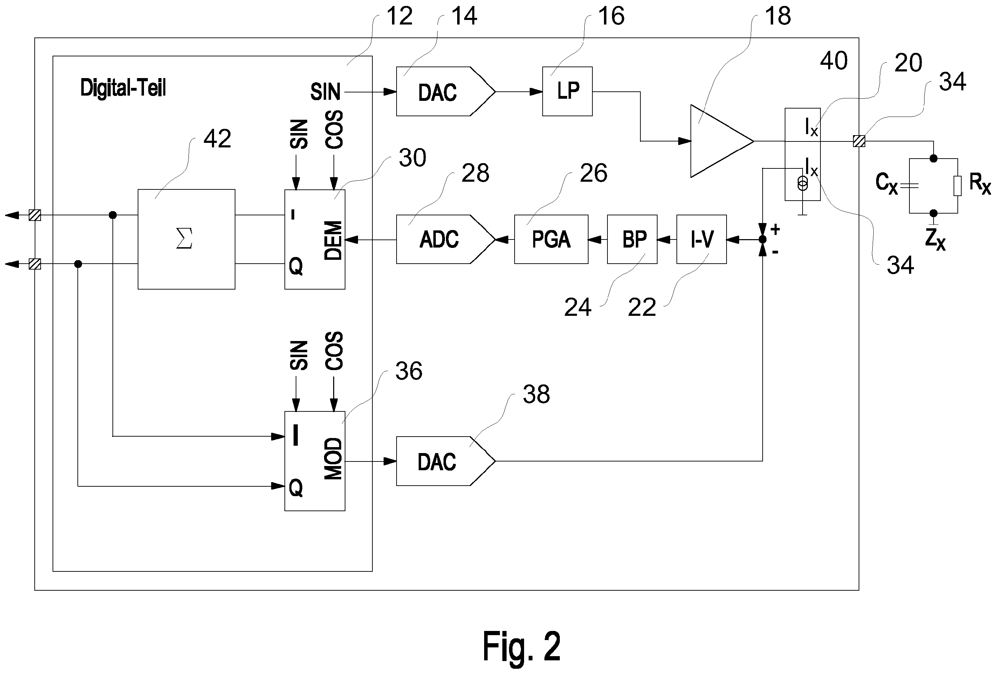

In Fig. 2 ist eine zweite Variante einer Schaltung 40 zum Vermessen einer Impedanz Z_{X} gezeigt. Soweit die einzelnen Bestandteile der Schaltung 40 denjenigen der Schaltung 10 der Fig. 1 entsprechen bzw. gleichen, sind sie in Fig. 2 mit den gleichen Bezugszeichen wie in Fig. 1 gekennzeichnet.

Der Unterschied der Schaltung 40 nach Fig. 2 gegenüber derjenigen nach Fig. 1 besteht in der Aufintegration der I- und Q-Signalanteile am Ausgang des I-Q-Demodulators 30 durch einen (Delta-)Integrator 42, der sowohl die I-Signalanteile als auch die Q-Signalanteile aufintegriert. Die Ausgangssignale des Integrators 42 werden dem I-Q-Modulator 36 zugeführt, um den digitalen Kompensationsstrom zu erzeugen, der über den DAC 38 in den analogen Kompensationsstrom umgewandelt wird, welcher wiederum vom Messstrom I_{X} subtrahiert wird. Die Funktion für den I-Ausgang des I-Q Modulators lautet folgendermaßen: $I = - sin \left(ωt\right) {I}_{Σ}$

Für den Q-Ausgang des I-Q Modulators ergibt sich folgende Gleichung: $Q = - cos \left(ωt\right) {Q}_{Σ}$

Hierbei sind , *Q*_{Σ} die Ausgänge des Delta Integrators 42.

Wenn sich die Impedanz Z_{X} von Intervall zu Intervall nicht mehr ändert, wirft der Demodulator 36 keine Signale mehr aus (Signal Null), was bedeutet, dass der vom Integrator 42 zuletzt berechnete Impedanzwert weiterhin gilt. Verändert sich der Impedanzwert, weichen die Ausgangssignale des Demodulators 36 von Null ab. Dadurch ändert sich der Integratorausgang 42 und somit auch der Kompensationsstrom, der im nächsten Messintervall vom Messstrom I_{X} subtrahiert wird. Wenn sich zwischenzeitlich die Impedanz Z_{X} nicht geändert hat, entstehen am Ausgang des Demodulators 36 wieder Null-Signale.

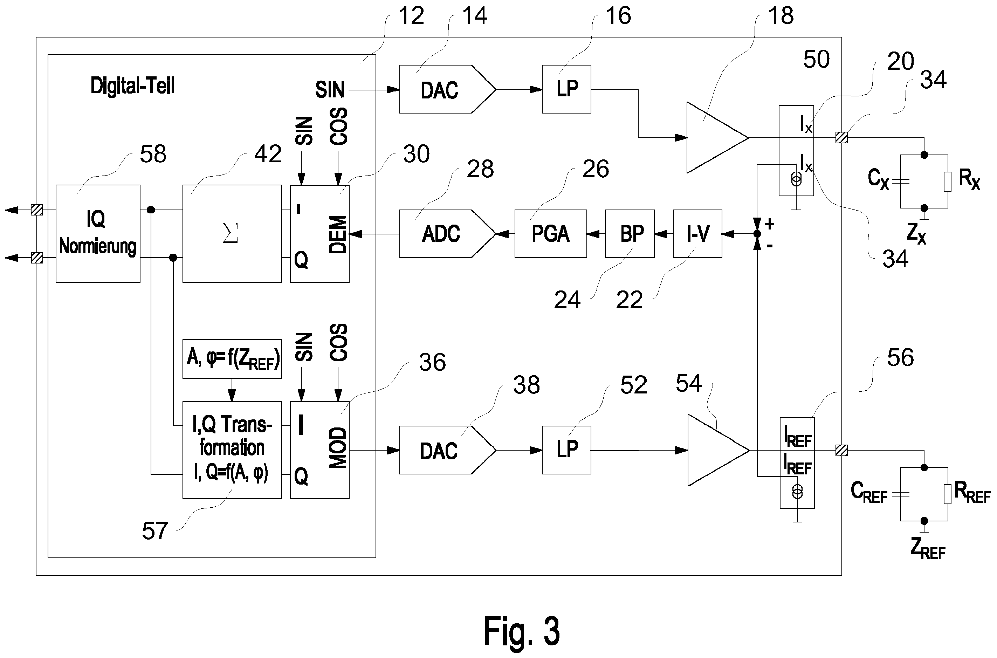

Eine weitere Variante einer Schaltung 50 zur Vermessung einer sich während des Betriebs potenziell ändernden Impedanz Z_{X} ist in Fig. 3 gezeigt. Auch hier gilt, dass diejenigen Komponenten der Schaltung 50, die denjenigen der Schaltung 10 nach Fig. 2 gleichen bzw. diesen entsprechen, in Fig. 3 mit den gleichen Bezugszeichen wie in Fig. 2 gekennzeichnet sind.

In dem Beispiel nach Fig. 3 wird für die Erzeugung des Kompensationsstroms eine Referenz-Impedanz Z_{REF} angeregt und deren induzierter Strom I_{REF} genutzt. Dazu wird im Digital-Teil 12 mittels des I-Q-Modulators 36 eine digitale Kompensationsspannung erzeugt, der nach einer DAC-Umwandlung im DAC 38 und gegebenenfalls einer Filterung in einem Tiefpassfilter 52 vermittels eines Treibers 54 an die Referenz-Impedanz Z_{REF} angelegt wird.

Durch einen Stromspiegel 56 wird der induzierte Strom I_{REF} gespiegelt und vom gespiegelten Messstrom I_{X} in bekannter Weise subtrahiert.

Im Digital-Teil 12 kommt es wieder zu einer Aufintegration der I- und Q-Signalanteile des I-Q-Demodulators 30, wobei die Ausgangssignale des Integrators 42 einer I-Q-Transformation in einer Schaltung 50 unterzogen werden. Hintergrund dafür ist, dass die Ausgänge des Delta-Integrators für die I- und die Q-Signalanteile des I-Q-Demodulators 30 gegebenenfalls vertauscht werden müssen, und zwar in Abhängigkeit davon, ob die Referenz-Impedanz Z_{REF} lediglich aus einem Kondensator oder ausschließlich aus einem Widerstand besteht. Wenn Z_{REF} nur mit Hilfe eines Kondensators realisiert wäre, dann müsste der I-Ausgang des Delta-Integrators 42 mit dem invertierten Q-Eingang des I-Q-Modulators 36 und der Q-Ausgang des Delta-Integrators mit dem I-Eingang des I-Q Modulators 36 verbunden werden. Bestünde Z_{REF} ausschließlich aus einem Widerstand, dann müsste ähnlich wie in Fig. 2 der I-Ausgang des Delta-Integrators 42 mit dem I-Eingang des I-Q-Modulators 36 und der Q-Ausgang des Delta-Integrators 42 mit dem Q-Eingang des I-Q-Modulators 36 verbunden werden. Für "Mischfälle", bei denen Z_{REF} sowohl einen imaginären, z.B. kapazitiven Anteil als auch einen realen, z.B. resistiven Anteil aufweist, bedarf es also einer Transformation, so dass Änderungen der Kapazität und des Widerstands der zu vermessenden Impedanz Z_{X} auch nur den Imaginärteil (Q-Anteil) bzw. nur den Real-Teil (I-Anteil) des I-Q-Demodulators 30 im Messergebnis ändern, muss die Kompensator phasenneutral erfolgen. Hierzu dient die I-Q-Transformationsschaltung 57 zur Drehung der Phasenverschiebung auf Grund von Z_{REF}, so dass sich in der Summe -180° ergeben. Die Transformationsgleichung für den I-Ausgang des I-Q Modulators lautet folgendermaßen: $I = - A sin \left(ωt\right) \left[{I}_{Σ} cos\left(φ\right)+{Q}_{Σ} sin\left(φ\right)\right]$

Für den Q-Ausgang des I-Q Modulators ergibt sich folgende Gleichung: $Q = - A cos \left(ωt\right) \left[-{I}_{Σ} sin\left(φ\right)+{Q}_{Σ} cos\left(φ\right)\right] .$

Hierbei sind , *Q*_{Σ} die Ausgänge des Delta Integrators. Die Phase φ erzeugt die Phasenverschiebung, die aufgrund von Z_{REF} zur Erzielung der Phasenneutralität notwendig ist: $φ = atan \left(\frac{2 π {f}_{Sig} {C}_{Ref}}{1 / {R}_{Ref}}\right)$

Für die Amplitude A ergibt sich: $A = \frac{0.5 / {R}_{Norm}}{\sqrt{1 / {R}_{Ref}^{2} + {\left({ωC}_{Ref}\right)}^{2}}}$

Mit Hilfe des Parameters R_{NORM} wird eine I-Q-Normierung durchgeführt. Diese bewirkt, dass dann, wenn die Kapazität Cx der zu vermessenden Impedanz Z_{X} gleich der Normierungsgröße R_{NORM} = 1/ ωC_{X} ist (oder auch der Widerstand R_{X} der zu vermessenden Impedanz Z_{X} gleich dem Parameter R_{NORM} = R_{X} ist), das Messergebnis des Imaginär- bzw. Real-Teils zu eins wird. Diese Amplituden-Normierung kann mit Hilfe der I-Q-Transformation vorgenommen werden oder sie erfolgt außerhalb der Regelschleife am Ausgang des Delta-Integrators 42, wie in Fig. 3 bei 58 gezeigt.

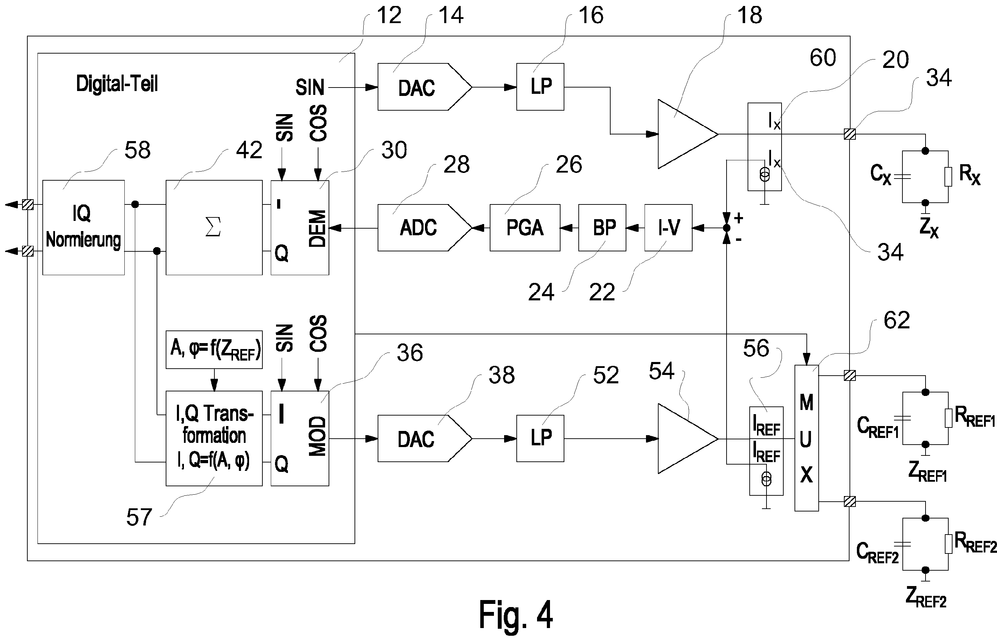

Ein weiteres Ausführungsbeispiel einer Schaltung 60 zur Vermessung einer Impedanz Z_{X} ist in Fig. 4 gezeigt. Auch hier gilt, dass die Einzelkomponenten der Schaltung 60, sofern sie denjenigen der Schaltung 50 entsprechen oder gleichen, in Fig. 4 mit den gleichen Bezugszeichen wie in Fig. 3 bezeichnet sind.

Der Unterschied der Schaltung 60 gegenüber derjenigen nach Fig. 3 ist in der Umschaltbarkeit der Referenz-Impedanz auf verschieden große Referenz-Impedanzen Z_{REF1} und Z_{REF2} zu sehen. Es kann auch zwischen mehreren diskreten Referenz-Impedanzen ausgewählt werden. Die Umschaltung erfolgt mit Hilfe eines Multiplexers 62, der vom Digital-Teil 12 ein Steuersignal erhält und die Kompensationsspannung auf die ausgewählte der mehreren Referenz-Impedanzen Z_{REF1}, Z_{REF2}, ... schaltet. Über den gleichen Multiplexer 62 oder einen weiteren Multiplexer (nicht gezeigt) wird der induzierte Kompensationsstrom I_{REF} einem Stromspiegel zugeführt. Danach verhält sich die Abfolge genauso, wie in Fig. 3 gezeigt.

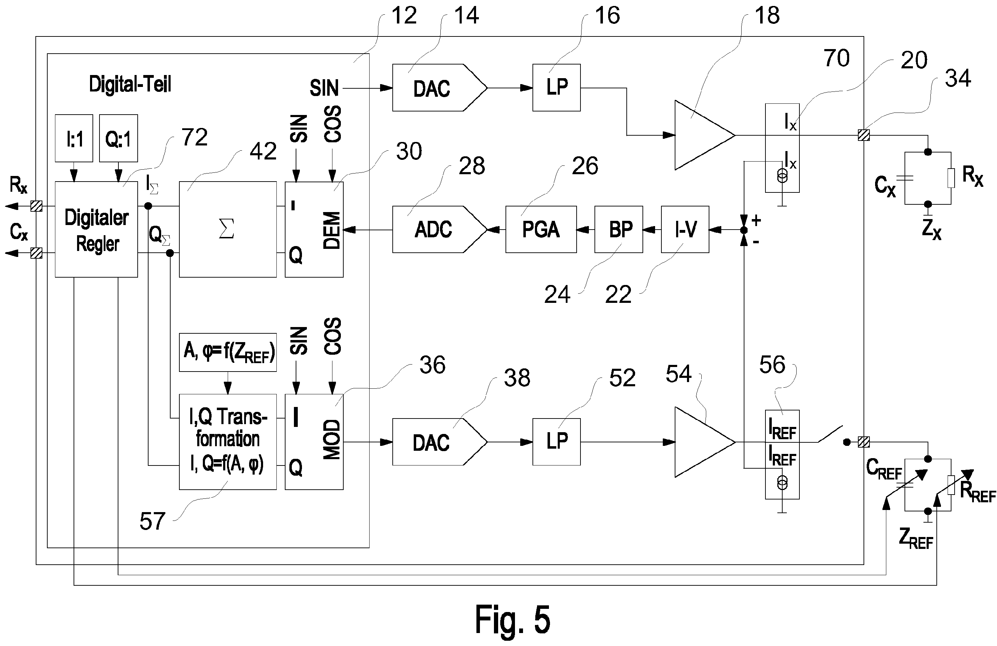

Ein letztes Ausführungsbeispiel einer Schaltung 70 zur Vermessung einer Impedanz Z_{X} ist in Fig. 5 gezeigt. Auch hier gilt, dass die Einzelkomponenten der Schaltung 70, sofern sie denjenigen der Schaltung 60 entsprechen oder gleichen, in Fig. 5 mit den gleichen Bezugszeichen wie in Fig. 4 bezeichnet sind.

Im Unterschied zur Schaltung 60 nach Fig. 4 wird bei der Schaltung 70 nach Fig. 5 nicht auf verschiedene diskrete Impedanz-Referenzen umgeschaltet, sondern vielmehr eine Referenz-Impedanz Z_{REF} verwendet, deren Kapazität C_{REF} und deren Widerstand R_{REF} quasi stufenlos verstellbar sind. Die Ansteuersignale kommen aus dem Digital-Teil 12. Dann gibt der digitale Regler 72 als I-Anteil den R_{X} entsprechenden Wert und als Q-Anteil den Z_{X} entsprechenden Wert aus. Das bedeutet, dass R_{X} = R_{REF} und Cx = C_{REF} ist. Kann allerdings Cx größer als der für C_{REF} größtmöglich einstellbare Wert und R_{X} größer als der für R_{REF} größtmöglich einstellbare Wert werden, müssten die Vorgaben für den digitalen Regler 72 kleiner als 1, also z.B. 0,1 sein, womit der Ausgang des digitalen Reglers 72 dann einen I-Anteil und einen Q-Anteil ausgeben würde, die jeweils 1/10 vom eingestellten Wert für C_{REF} bzw. R_{REF} betragen, R_{X} und Cx der zu vermessenden Impedanz Z_{X} also um den Faktor 10 größer sind, als vom digitalen Regler 72 ausgegeben. Diese beispielsweise als Kapazitäts- und Widerstands-Decade realisierte Referenzimpedanz Z_{REF} wird mit Hilfe einer übergeordneten Regelschleife so eingestellt, dass der I,Q-Ausgang des Delta-Integrators 42 im eingeschwungenen Zustand den Wert eins einnimmt. Der Messwert der unbekannten Impedanz Z_{X} wird dann durch die Einstellung der Z_{REF}-Decade repräsentiert. Der Vorteil der Sensorarchitekturen Abbildungen der Fign. 2 bis 4 besteht darin, dass Nichtlinearitäten in der Signalkette (I-V-Wandler 22, Bandpassfilter 24, Verstärker 26, ADC28) keinen Einfluss auf die Messgenauigkeit haben. Der in Fig. 5 gezeigte Sensor ist zusätzlich auch im Signal- und Referenzpfad (DAC14, DAC 38, Stromspiegel 20, Stromspiegel 56) unempfindlich gegenüber Nichtlinearitäten. Die Messgenauigkeit wird lediglich durch die Z_{REF}-Decade bestimmt.

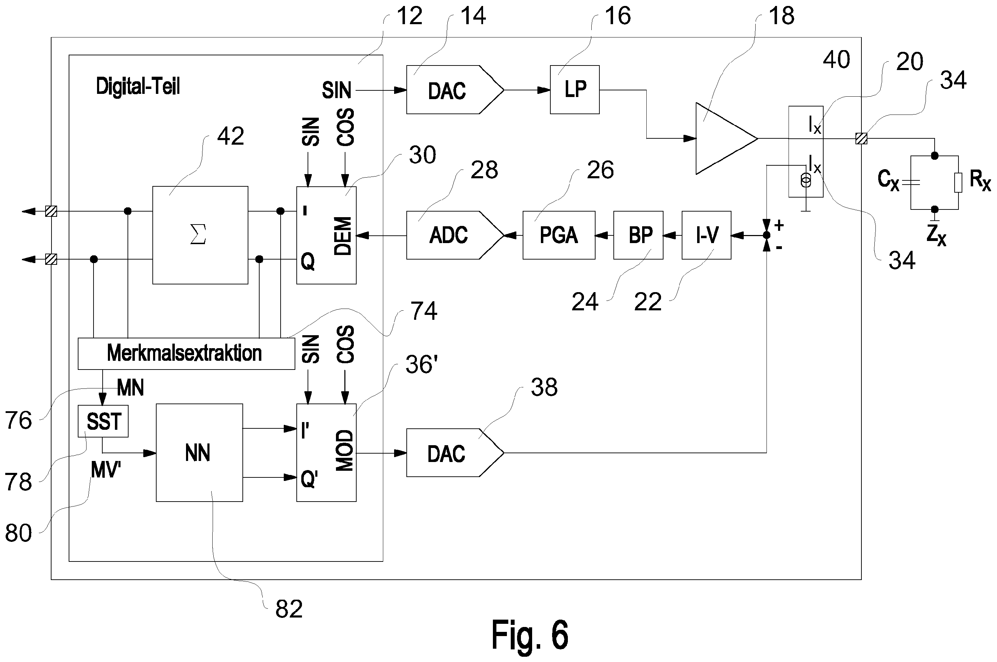

Abschließend wird anhand der Fig. 6 noch ein sechstes Ausführungsbeispiel der Erfindung beschrieben. Dieses Ausführungsbeispiel unterscheidet sich insofern von den anderen Ausführungsbeispielen, als zur Generierung des Offset-Signals (Kompensationsstrom) vorzugsweise computerimplementierte Elemente der künstlichen Intelligenz an Hardware- und Softwareelementen der künstlichen Intelligenz eingesetzt werden.

Wie beim Ausführungsbeispiel der Fig. 2 wird das Signal am Ausgang des Delta-Integrators dem I-Q-Modulator 36' zugeführt, allerdings unter zwischenzeitlicher Verarbeitung mittels Merkmalsextraktion 74, in die die I-Q-Daten am Ausgang des Demodulators 30 und die Signale nach der Verarbeitung im Delta-Integrator 42 eingehen. Der sich daraus ergebende Merkmalsvektor 76 gelangt zu einer Signifikanzsteigerungsstufe 78, wodurch sich ein insoweit geänderter Merkmalsvektor 80 ergibt, der einem vorzugsweise computerimplementierten neuronalen Netz 82 zugeführt wird, dessen Aufbau beliebig ist und entsprechend den typischerweise bekannten neuronalen Netzen entspricht. Die Signifikanzsteigerungsstufe 78 kann beispielsweise durch einen Prozessor der Vorrichtung gebildet sein, der unter anderem ein computerimplementiertes Verfahren zur Signifikanzsteigerung des Merkmalsvektors 76 ausführt, um beispielsweise den geänderten Merkmalsvektor 80 zu erzeugen. Am Ausgang des neuronalen Netzes 82 werden dann die I- und Q-Daten für den I-Q-Modulator 36' ausgegeben, dessen Ausgangssignal nach Wandlung im DAC 38 in ein Analogsignal den Kompensationsstrom vorgibt.

Die bei diesem Ausführungsbeispiel vorgesehene Merkmalsextraktion erfasst also die I- und Q-Daten des Demodulators und das Ausgangssignal nach Verarbeitung im Delta-Integrator 42 und erzeugt daraus den Merkmalsvektor MV (siehe Bezugszeichen 76).

Informationen zu Merkmalsvektoren findet man beispielsweise unter https://de.wikipedia.org/wiki/Merkmalsvektor.

Für jede Dimension des Merkmalsvektors existiert ein zulässiger Wertebereich mit einer bestimmten Größe. Eine Signifikanz-Steigerungsstufe SST (siehe Bezugszeichen 78) verzerrt den Merkmalsvektor nun so, dass in jeder Dimension jeweils 50% der Trainingswerte eine oberhalb der Schwelle des halben Wertebereichs und 50% unterhalb der Schwelle des halben Wertebereichs aber vorzugsweise immer noch im zulässigen Wertebereich für die jeweilige Dimension liegen (es handelt sich hier um beispielhafte Angaben). Die Signifikanzsteigerungsstufe 78 erzeugt eine Abbildung entsprechend einem Matrixpolynom. Dabei wird für die Bildung des n-ten Summanden des Polynoms eine Verzerrungsmatrix Xₙ mit n Instanzen des Merkmalsvektors MV durch Matrix-Vektormultiplikation X*MVⁿ gebildet und über alle Summanden des Polynoms addiert.

Andere Methoden der Clusterung sind möglich.

Die Signifikanzsteigerungsstufe kann die Signifikanz eines Merkmalsvektors auf Basis von Trainingsdaten auf beispielsweise eine der nachfolgend genannten verschiedene Weise steigern:

### Feature Engineering

Durch die Extraktion von Werten neuer Merkmale (Feature Engineering) kann die Signifikanzsteigerungsstufe relevante Informationen aus den vorhandenen Merkmalen des Merkmalsvektors MV extrahieren und in Form neuer Dimensionen dem Merkmalsvektor MV hinzufügen. Dies kann die Signifikanz des Merkmalsvektors erhöhen.

### Feature Selection

Statt alle verfügbaren Merkmale des Merkmalsvektors zu verwenden, kann zur Signifikanzsteigerung die Dimensionalität des Merkmalsvektors wieder durch Merkmalsauswahl in Abhängigkeit vom Merkmalsvektor reduziert werden, um diejenigen Merkmale auszuwählen, die die größte Relevanz für die aktuelle Mustererkennungsaufgabe haben.

Die Signifikanzsteigerung kann z.B. computerimplementierte maschinelle Lernverfahren verwenden, die beispielsweise Regularisierungstechniken wie L1- und L2-Regularisierung anwenden, um die Gewichtung von Merkmalen zu beeinflussen und die Signifikanz bestimmter Merkmale zu steuern.

### Ensemble-Methode

Die Signifikanzsteigerung kann Ensemble-Methoden wie Random Forests oder Gradient Boosting verwenden, um die Signifikanz von Merkmalsvektoren zu steigern, indem mehrere Modelle kombiniert und die besten Merkmale ausgewählt werden.

### Domänenwissen

Das Einbringen von Domänenwissen der Anwendungssituation der Vorrichtung und der Implementation entsprechender computerimplementierter Verfahren in der Signifikanzsteigerung kann dazu beitragen, die Signifikanz von Merkmalsvektoren MV' (siehe Bezugszeichen 80) zu steigern, indem relevante Informationen in das Modell einfließen. Dies kann durch manuelle Anpassungen oder die Verwendung von vortrainierten Modellen mit Domänenwissen erreicht werden.

Das neuronale Netz NN (siehe Bezugszeichen 82) wertet den jeweiligen mit gesteigerter Selektivität versehenen Merkmalsvektor aus.

Die zuvor genannten Ausführungen zur Merkmalsextraktion und zur Signifikanzsteigerung sind nicht auf das Ausführungsbeispiel der Fig. 6 beschränkt.

### BEZUGSZEICHENLISTE

- 10: Schaltung
- 12: Digital-Teil
- 14: DAC
- 16: Tiefpassfilter
- 18: Treiber
- 20: Stromspiegel
- 22: I-V-Wandler
- 24: Bandpassfilter
- 26: Verstärker
- 28: ADC
- 30: I-Q-Demodulator
- 32: Digitalfilter
- 34: Eingang
- 36: I-Q-Modulator
- 36': I-Q-Modulator
- 38: DAC
- 40: Schaltung
- 42: Delta-Integrator
- 50: Schaltung
- 52: Tiefpassfilter
- 54: Treiber
- 56: Stromspiegel
- 57: I-Q-Transformationsschaltung
- 58: I-Q-Normierungsschaltung
- 60: Schaltung
- 62: Multiplexer
- 70: Schaltung
- 72: digitaler Regler
- 74: Merkmalsextraktion
- 76: Merkmalsvektor
- 78: Signifikanzsteigerungsstufe
- 80: Merkmalsvektor mit gesteigerter Signifikanz
- 82: neuronales Netz
- Z_{REF1}: Referenz-Impedanz
- Z_{REF2}: Referenz-Impedanz
- Z_{X}: zu vermessende Impedanz
- I_{X}: Messstrom
- I_{REF}: Referenzstrom

## Patentansprüche

1. Verfahren zur in mehreren Intervallen und damit wiederholt erfolgenden Ermittlung eines für die Größe und/oder die Veränderung einer Impedanz charakteristischen elektrischen Signals, die sich unter dem Einfluss eines magnetischen, elektrischen und/oder elektromagnetischen Feldes ändert, das sich seinerseits durch ein sich der Impedanz annäherndes Objekt verändert, wobei bei dem Verfahren
- die Intervalle mindestens eine Gruppe von Messintervallen, die ein Messintervall oder mehrere aufeinanderfolgende Messintervalle aufweist, und mindestens ein Kompensationsintervall umfassen, das oder die zeitlich vor der mindestens einen Gruppe oder vor jeder Gruppe von Messintervallen positioniert ist bzw. sind,
- pro Messintervall
- die Impedanz (Z_{X}) mit einer sinusförmigen Anregungsspannung beaufschlagt wird und
- in der Impedanz (Z_{X}) als Folge der Anregungsspannung ein Messstrom (I_{X}) induziert wird,
- wobei der Messstrom (I_{X}) eines Kompensationsintervalls als ein Kompensationsstrom für mindestens ein nachfolgendes Messintervall genutzt wird, indem der Kompensationsstrom in dem mindestens einen nachfolgenden Messintervall von dem Messstrom (I_{X}) dieses Messintervalls zur Bildung eines analogen Auswertestromsignals subtrahiert wird, und
- das Auswertestromsignal das für die Größe und/oder die Veränderung der Impedanz (Z_{X}) charakteristische Signal ist.

2. Verfahren nach Anspruch 1, **dadurch gekennzeichnet, dass** der Kompensationsstrom nach seiner Ermittlung von einer Signalerzeugungseinheit erzeugt wird, um von dem Messstrom (I_{X}) des mindestens einen Messintervalls subtrahiert zu werden.

3. Verfahren nach Anspruch 1 oder 2, **dadurch gekennzeichnet, dass** das analoge Auswertestromsignal verstärkt wird und dass das dergestalt verstärkte Auswertestromsignal das für die Größe und/oder die Veränderung der Impedanz charakteristische Signal ist.

4. Verfahren nach einem der Ansprüche 1 bis 3, **dadurch gekennzeichnet, dass** die Intervalle eine erste Gruppe von Messintervallen aufweisen, die zeitlich vor dem ersten Kompensationsintervall liegt, und dass für das oder die Messintervalle dieser ersten Gruppe ein Kompensationsstrom bereitgestellt wird, und/oder dass die Größe der Impedanz (Z_{X}) im Ausgangszustand vor einer ersten Veränderung bekannt ist.

5. Verfahren nach einem der Ansprüche 1 bis 4, **dadurch gekennzeichnet, dass** der Kompensationsstrom berechnet wird mittels
- eines neuronalen Netzes beliebiger Art und beliebigem Aufbaus und/oder
- eines Hidden Markov Modells und/oder
- eines Petrinetzes und/oder automatischen Lernens jeder Art zur Generierung von Erkenntnissen aus der Vergangenheit und früheren Erfahrungen, wie z.B. maschinelles Lernen, Deep Learning und/oder einer Verarbeitung von Prädiktoren, d.h. Vorhersagevariablen aus in der Vergangenheit registrierten Ereignissen.

6. Verfahren nach einem der Ansprüche 1 bis 5, **dadurch gekennzeichnet, dass** das ggf. verstärkte analoge Auswertestromsignal nach einer Analog-Digital-Konvertierung einer I-Q-Demodulation unterzogen wird, wobei der I-Signalanteil und/oder der Q-Signalanteil der I-Q-Demodulation das für die Größe und/oder die Veränderung der Impedanz (Z_{X}) charakteristische Signal ist, wobei insbesondere der Kompensationsstrom in der Signalerzeugungseinheit anhand der Parameter der digitalen I-Q-Demodulation in dem zeitlich jeweils letzten Kompensationsintervall digital erzeugt wird.

7. Verfahren nach einem der Ansprüche 1 bis 6, **dadurch gekennzeichnet, dass** als Impedanz (Z_{X}) eine resistive, induktive und/oder kapazitive Impedanz ausgewählt wird, wobei die kapazitive Impedanz als Kondensator mit Dielektrikum oder als Elektrodenfläche ausgebildet ist.

8. Verfahren zur in mehreren Intervallen und damit wiederholt erfolgenden Ermittlung eines für die Größe und/oder die Veränderung einer Impedanz charakteristischen elektrischen Signals, die sich unter dem Einfluss eines magnetischen, elektrischen und/oder elektromagnetischen Feldes ändert, das sich seinerseits durch ein sich der Impedanz annäherndes Objekt verändert, wobei bei dem Verfahren
- pro Intervall
- die Impedanz (Z_{X}) mit einer sinusförmigen Anregungsspannung beaufschlagt wird und
- in der Impedanz (Z_{X}) als Folge der Anregungsspannung ein Messstrom (I_{X}) induziert wird,
- die Differenz aus dem Messstrom (I_{X}) und einem Kompensationsstrom dem Eingang eines analogen oder digitalen Integrators (42) zugeführt wird, dessen Ausgangs ggfs. nach einer Digital-Analog-Konvertierung den Kompensationsstrom liefert, und
- der Ausgang des Integrators (42) das für die Größe und/oder Veränderung der Impedanz (Z_{X}) charakteristische Signal bildet.

9. Verfahren nach Anspruch 8, **dadurch gekennzeichnet, dass** das Differenzsignal aus der Differenz von Messstrom und Kompensationsstrom, ggfs. nach einer Verstärkung, einer Analog-Digital-Konvertierung unterzogen und anschließend einem digitalen I-Q-Demodulator (30) zugeführt wird, dessen I- und Q-Signalanteile dem Eingang eines digitalen Integrators (42) zugeführt werden, und dass zur Bildung des Kompensationsstroms die über die Zeit integrierten I- und Q-Signalanteile in einem digitalen I-Q-Modulator (36) moduliert werden, dessen Ausgang mit einem Digital-Analog-Konverter (38) verbunden ist, der den analogen Kompensationsstrom ausgibt.

10. Verfahren zur in mehreren Intervallen und damit wiederholt erfolgenden Ermittlung eines für die Größe und/oder die Veränderung einer Impedanz charakteristischen elektrischen Signals, die sich unter dem Einfluss eines magnetischen, elektrischen und/oder elektromagnetischen Feldes ändert, das sich seinerseits durch ein sich der Impedanz annäherndes Objekt verändert, wobei bei dem Verfahren
- pro Intervall
- die Impedanz (Z_{X}) mit einer sinusförmigen Anregungsspannung beaufschlagt wird,
- in der Impedanz (Z_{X}) als Folge der Anregungsspannung ein Messstrom (I_{X}) induziert wird,
- eine Referenzimpedanz (Z_{REF}) bekannter Größe mit einer zur Anregungsspannung um 180° phasenverschobenen Kompensationsspannung beaufschlagt wird und
- in der Referenzimpedanz (Z_{REF}) als Folge der Kompensationsspannung ein Kompensationsstrom (I_{REF}) induziert wird,
- die Differenz aus dem Messstrom (I_{X}) und dem Kompensationsstrom (I_{REF}), gegebenenfalls nach einer Verstärkung, dem Eingang eines analogen oder digitalen Integrators (42) zugeführt wird, dessen Ausgang gegebenenfalls nach einer Digital-Analog-Konvertierung die Größe der Kompensationsspannung liefert,
- die Kompensationsspannung erzeugt wird und
- der Ausgang des Integrators (42)das für die Größe und/oder die Veränderung der Impedanz charakteristische Signal ist.

11. Verfahren nach Anspruch 10 **gekennzeichnet durch** mehrere Referenzimpedanzen (Z_{REF}) mit jeweils bekannter Größe, wobei je nach Größe der Kompensationsspannung eine dieser Referenzimpedanzen (Z_{REF}) mit der Kompensationsspannung beaufschlagt wird und als Folge davon ein Kompensationsstrom (I_{REF}) liefert.

12. Verfahren nach Anspruch 10, **dadurch gekennzeichnet, dass** die Größe der Referenzimpedanz (Z_{REF}) variabel einstellbar ist und mit Hilfe eines Reglers (72), der einen das Signal am Ausgang des Integrators (42) empfangenden Eingang und einen Ausgang aufweist, verändert wird, wobei der Ausgang des Reglers (72) das für die Größe und/oder Veränderung der Impedanz charakteristische Signal liefert.

13. Verfahren nach einem der Ansprüche 10 bis 11, **dadurch gekennzeichnet, dass** das Differenzsignal aus der Differenz von Messstrom (I_{X}) und Kompensationsstrom (I_{REF}), gegebenenfalls nach einer Verstärkung, einer Analog-Digital-Konvertierung unterzogen und anschließend einem digitalen I-Q-Demodulator (30) zugeführt wird, dessen I- und Q-Signalanteile dem Eingang eines digitalen Integrators (42) zugeführt werden, und dass zur Bildung der Kompensationsspannung die über die Zeit integrierten I- und Q-Signalanteile in einem digitalen I-Q-Modulator (36) moduliert werden, dessen Ausgang mit einem Digital-Analog-Konverter (38) verbunden ist, der den analogen Kompensationsstrom ausgibt.

14. Verfahren nach einem der Ansprüche 10 bis 12, **dadurch gekennzeichnet, dass** das Differenzsignal aus der Differenz von Messstrom (I_{X}) und Kompensationsstrom (I_{REF}), gegebenenfalls nach einer Verstärkung, einer Analog-Digital-Konvertierung unterzogen und anschließend einem digitalen I-Q-Demodulator (30) zugeführt wird, dessen I- und Q-Signalanteile dem Eingang eines digitalen Integrators (42) zugeführt werden, und dass zur Bildung der Kompensationsspannung die über die Zeit integrierten I- und Q-Signalanteile in einem digitalen I-Q-Modulator (36) moduliert werden, dessen Ausgang mit einem Digital-Analog-Konverter (38) verbunden ist, der den analogen Kompensationsstrom ausgibt und außerdem in einer überlagerten Regelschleife mit dem digitalen Regler (72) der I- und Q-Anteil der Referenzimpedanz in Abhängigkeit des I-Q-Ausgangs des digitalen Integrators (42) nach den Regelvorgaben für I- und Q-Anteil eingestellt wird.

15. Verfahren zur in mehreren Intervallen und damit wiederholt erfolgenden Ermittlung eines für die Größe und/oder die Veränderung einer Impedanz charakteristischen elektrischen Signals, die sich unter dem Einfluss eines magnetischen, elektrischen und/oder elektromagnetischen Feldes ändert, das sich seinerseits durch ein sich der Impedanz annäherndes Objekt verändert, wobei bei dem Verfahren
- pro Intervall
- die Impedanz (Z_{X}) mit einer sinusförmigen Anregungsspannung beaufschlagt wird und
- in der Impedanz (Z_{X}) als Folge der Anregungsspannung ein Messstrom (I_{X}) induziert wird,
- anhand des Messstroms (I_{X}) oder einer daraus abgeleiteten Größe ein Kompensationsstrom berechnet wird, mittels
- eines neuronalen Netzes beliebiger Art und beliebigem Aufbaus und/oder
- eines Hidden Markov Modells und/oder
- eines Petrinetzes und/oder automatischen Lernens jeder Art zur Generierung von Erkenntnissen aus der Vergangenheit und früheren Erfahrungen, wie z.B. maschinelles Lernen, Deep Learning und/oder einer Verarbeitung von Prädiktoren, d.h. Vorhersagevariablen aus in der Vergangenheit registrierten Ereignissen, und
- die Differenz aus Messstrom (I_{X}) und Kompensationsstrom das für die Größe und/oder Veränderung der Impedanz (Z_{X}) charakteristische Signal bildet.

## Claims

1. A method for determining, at multiple intervals and thus repeatedly, an electrical signal characteristic of the magnitude of and/or the change in an impedance which changes under the influence of a magnetic, electric and/or electromagnetic field which for its part changes due to an object approaching the impedance, wherein in the method
- the intervals comprise at least one group of measurement intervals, which has one or more consecutive measurement intervals, and at least one compensation interval positioned chronologically before the at least one group or before each group of measurement intervals,
- per measurement interval
- a sinusoidal excitation voltage is applied to the impedance (Zₓ), and
- a measuring current (Iₓ) is induced in the impedance (Zₓ) as a result of the excitation voltage,
- the measuring current (Iₓ) of a compensation interval is used as a compensation current for at least one subsequent measurement interval by subtracting the compensation current in the at least one subsequent measurement interval from the measuring current (Iₓ) of this measurement interval to form an analog evaluation current signal, and
- the evaluation current signal is the signal that is characteristic of the magnitude of and/or the change in the impedance (Zₓ).

2. The method according to claim 1, **characterized in that** the compensation current is generated by a signal generation unit after it has been determined in order to be subtracted from the measuring current (I_{X}) of the at least one measurement interval.

3. The method according to claim 1 or 2, **characterized in that** the analog evaluation current signal is amplified and that the evaluation current signal amplified in this way is the signal characteristic of the magnitude and/or the change in the impedance.

4. The method according to one of claims 1 to 3, **characterized in that** the intervals comprise a first group of measurement intervals which chronologically precedes the first compensation interval, and **in that** a compensation current is provided for the measurement interval or intervals of this first group, and/or **in that** the magnitude of the impedance (Z_{X}) is known in the initial state before a first change.

5. The method according to any of claims 1 to 4, **characterized in that** the compensation current is calculated by means of
- a neural network of any type and any structure and/or
- a Hidden Markov Model and/or
- a Petri net and/or automatic learning of any kind for generating knowledge from the past and previous experiences, such as machine learning, deep learning and/or a processing of predictors, i.e. predictive variables from events registered in the past.

6. The method according to one of claims 1 to 5, **characterized in that** the possibly amplified analog evaluation current signal is subjected to an I-Q demodulation after an analog-to-digital conversion, the I signal component and/or the Q signal component of the I-Q demodulation being the signal characteristic of the magnitude and/or the change in the impedance (Z_{X}), wherein, in particular, the compensation current in the signal generation unit is digitally generated based on the parameters of the digital I-Q demodulation during the respective chronologically last compensation interval.

7. The method according to one of claims 1 to 6, **characterized in that** a resistive, inductive and/or capacitive impedance is selected as the impedance (Z_{X}), the capacitive impedance being designed as a capacitor with dielectric or as an electrode surface.

8. A method for determining, at multiple intervals and thus repeatedly, an electrical signal characteristic of the magnitude of and/or the change in an impedance which changes under the influence of a magnetic, electric and/or electromagnetic field which for its part changes due to an object approaching the impedance, wherein in the method
- per interval
- a sinusoidal excitation voltage is applied to the impedance (Zₓ), and
- a measuring current (Iₓ) is induced in the impedance (Zₓ) as a result of the excitation voltage,
- the difference between the measuring current (Iₓ) and a compensation current is fed to the input of an analog or digital integrator (42), the output of which supplies the compensation current, if necessary after digital-to-analog conversion, and
- the output of the integrator (42) forms the signal characteristic of the magnitude and/or change in the impedance (Zₓ).

9. The method according to claim 8, **characterized in that** the differential signal from the difference between the measuring current and the compensation current is subjected to an analog-to-digital conversion, if necessary after amplification, and is then fed to a digital I-Q demodulator (30), whose I and Q signal components are fed to the input of a digital integrator (42), and that to form the compensation current, the I and Q signal components integrated over time are modulated in a digital I-Q modulator (36) whose output is connected to a digital-to-analog converter (38) that outputs the analog compensation current.

10. A method for determining, at multiple intervals and thus repeatedly, an electrical signal characteristic of the magnitude of and/or the change in an impedance which changes under the influence of a magnetic, electric and/or electromagnetic field which for its part changes due to an object approaching the impedance, wherein in the method
- per interval
- a sinusoidal excitation voltage is applied to the impedance (Zₓ),
- a measuring current (Iₓ) is induced in the impedance (Zₓ) as a result of the excitation voltage,
- a reference impedance (Z_{REF}) of known magnitude is subjected to a compensation voltage that is 180° out of phase with the excitation voltage, and
- a compensation current (I_{REF}) is induced in the reference impedance (Z_{REF}) as a result of the compensation voltage,
- the difference between the measuring current (Iₓ) and the compensation current (I_{REF}) is fed, possibly after amplification, to the input of an analog or digital integrator (42), the output of which provides the magnitude of the compensation voltage, possibly after digital-to-analog conversion,
- the compensation voltage is generated and
- the output of the integrator (42) is the signal characteristic of the magnitude and/or the change in the impedance.

11. The method according to claim 10, **characterized by** a plurality of reference impedances (Z_{REF}), each having a known magnitude, one of these reference impedances (Z_{REF}) being subjected to the compensation voltage depending on the magnitude of the compensation voltage and supplying a compensation current (I_{REF}) as a result.

12. The method according to claim 10, **characterized in that** the magnitude of the reference impedance (Z_{REF}) is variably adjustable and is varied by means of a controller (72) having an input receiving the signal at the output of the integrator (42) and an output, the output of the controller (72) providing the signal characteristic of the magnitude and/or change in the impedance.

13. The method according to any one of claims 10 to 11, **characterized in that** the differential signal from the difference between the measuring current (Iₓ) and the compensation current (I_{REF}) is subjected to an analog-to-digital conversion, if necessary after amplification, and is then fed to a digital I-Q demodulator (30), whose I and Q signal components are fed to the input of a digital integrator (42), and that to form the compensation voltage, the I and Q signal components integrated over time are modulated in a digital I-Q modulator (36) whose output is connected to a digital-to-analog converter (38) that outputs the analog compensation current.

14. The method according to any one of claims 10 to 12, **characterized in that** the differential signal from the difference between the measuring current (Iₓ) and the compensation current (I_{REF}) is subjected to an analog-to-digital conversion, if necessary after amplification, and is then fed to a digital I-Q demodulator (30), whose I and Q signal components are fed to the input of a digital integrator (42), and that to form the compensation voltage, the I and Q signal components integrated over time are modulated in a digital I-Q modulator (36) whose output is connected to a digital-to-analog converter (38) that outputs the analog compensation current, and furthermore the I and Q components of the reference impedance are adjusted according to the control specifications for the I and Q components in a superimposed control loop with the digital controller (72) depending on the I-Q output of the digital integrator (42).

15. A method for determining, at multiple intervals and thus repeatedly, an electrical signal characteristic of the magnitude of and/or the change in an impedance which changes under the influence of a magnetic, electric and/or electromagnetic field which for its part changes due to an object approaching the impedance, wherein in the method
- per interval
- a sinusoidal excitation voltage is applied to the impedance (Zₓ), and
- a measuring current (Iₓ) is induced in the impedance (Zₓ) as a result of the excitation voltage,
- a compensation current is calculated on the basis of the measuring current (I_{X}) or a variable derived therefrom by means of
- a neural network of any type and any structure and/or
- a Hidden Markov Model and/or
- a Petri net and/or automatic learning of any kind for generating knowledge from the past and previous experiences, such as machine learning, deep learning and/or a processing of predictors, i.e. predictive variables from events registered in the past, and
- the difference between the measuring current (I_{X}) and the compensation current forms the signal characteristic of the magnitude and/or change in the impedance (Z_{X}).

## Revendications

1. Procédé permettant de déterminer, à plusieurs intervalles et donc de manière répétée, un signal électrique caractéristique de la valeur et/ou de la variation d'une impédance qui varie sous l'influence d'un champ magnétique, électrique et/ou électromagnétique, lequel est lui-même modifié par un objet se rapprochant de l'impédance, procédé dans lequel
- les intervalles comprennent au moins un groupe d'intervalles de mesure, qui comporte un intervalle de mesure ou plusieurs intervalles de mesure successifs, et au moins un intervalle de compensation, qui est ou sont positionné(s) dans le temps avant ledit au moins un groupe ou avant chaque groupe d'intervalles de mesure,
- à chaque intervalle de mesure,
- l'impédance (Z_{X}) est soumise à une tension d'excitation sinusoïdale, et
- un courant de mesure (I_{X}) est induit dans l'impédance (Z_{X}) sous l'effet de cette tension d'excitation,
- le courant de mesure (I_{X}) d'un intervalle de compensation est utilisé comme courant de compensation pour au moins un intervalle de mesure suivant, le courant de compensation étant soustrait, dans ledit au moins un intervalle de mesure suivant, du courant de mesure (I_{X}) de cet intervalle de mesure afin de constituer un signal de courant d'évaluation analogique, et
- le signal de courant d'évaluation est le signal caractéristique de la valeur et/ou de la variation de l'impédance (Z_{X}).

2. Procédé selon la revendication 1,
**caractérisé en ce que** le courant de compensation, une fois déterminé, est généré par une unité de génération de signal afin d'être soustrait du courant de mesure (I_{X}) dudit au moins un intervalle de mesure.

3. Procédé selon la revendication 1 ou 2,
**caractérisé en ce que** le signal de courant d'évaluation analogique est amplifié, et **en ce que** le signal de courant d'évaluation ainsi amplifié est le signal caractéristique de la valeur et/ou de la variation de l'impédance.

4. Procédé selon l'une des revendications 1 à 3,
**caractérisé en ce que** les intervalles comprennent un premier groupe d'intervalles de mesure situé dans le temps avant le premier intervalle de compensation, et **en ce qu'**un courant de compensation est fourni pour le ou les intervalles de mesure de ce premier groupe, et/ou **en ce que** la valeur de l'impédance (Z_{X}) à l'état initial, avant une première variation, est connue.

5. Procédé selon l'une des revendications 1 à 4,
**caractérisé en ce que** le courant de compensation est calculé à l'aide
- d'un réseau neuronal de type et de structure quelconques, et/ou
- d'un modèle de Markov caché, et/ou
- d'un réseau de Petri et/ou d'un apprentissage automatique de tout type permettant de générer des connaissances à partir du passé et d'expériences antérieures, comme par exemple l'apprentissage automatique, l'apprentissage profond, et/ou d'un traitement de prédicteurs, c'est-à-dire de variables prédictives issues d'événements enregistrés dans le passé.

6. Procédé selon l'une des revendications 1 à 5,
**caractérisé en ce que** le signal de courant d'évaluation analogique, éventuellement amplifié, est soumis à une démodulation I-Q après une conversion analogique-numérique, la composante de signal I et/ou la composante de signal Q de la démodulation I-Q étant le signal caractéristique de la valeur et/ou de la variation de l'impédance (Z_{X}), en particulier, le courant de compensation est généré numériquement dans l'unité de génération de signal à l'aide des paramètres de la démodulation I-Q numérique au cours du dernier intervalle de compensation dans le temps.

7. Procédé selon l'une des revendications 1 à 6,
**caractérisé en ce qu'**une impédance résistive, inductive et/ou capacitive est choisie comme impédance (Z_{X}), l'impédance capacitive étant réalisée sous la forme d'un condensateur avec un diélectrique ou d'une surface d'électrode.

8. Procédé permettant de déterminer, à plusieurs intervalles et donc de manière répétée, un signal électrique caractéristique de la valeur et/ou de la variation d'une impédance qui varie sous l'influence d'un champ magnétique, électrique et/ou électromagnétique, lequel est lui-même modifié par un objet se rapprochant de l'impédance, procédé dans lequel
- à chaque intervalle,
- l'impédance (Z_{X}) est soumise à une tension d'excitation sinusoïdale, et
- un courant de mesure (I_{X}) est induit dans l'impédance (Z_{X}) sous l'effet de cette tension d'excitation,
- la différence entre le courant de mesure (I_{X}) et un courant de compensation est appliquée à l'entrée d'un intégrateur analogique ou numérique (42) dont la sortie fournit, le cas échéant après une conversion numérique-analogique, le courant de compensation, et
- la sortie de l'intégrateur (42) constitue le signal caractéristique de la valeur et/ou de la variation de l'impédance (Z_{X}).

9. Procédé selon la revendication 8,
**caractérisé en ce que** le signal différentiel, résultant de la différence entre le courant de mesure et le courant de compensation, le cas échéant après une amplification, est soumis à une conversion analogique-numérique, puis est transmis à un démodulateur I-Q numérique (30) dont les composantes de signal I et Q sont transmises à l'entrée d'un intégrateur numérique (42), et **en ce que**, pour constituer le courant de compensation, les composantes de signal I et Q intégrées dans le temps sont modulées dans un modulateur I-Q numérique (36) dont la sortie est reliée à un convertisseur numérique-analogique (38) qui délivre le courant de compensation analogique.

10. Procédé permettant de déterminer, à plusieurs intervalles et donc de manière répétée, un signal électrique caractéristique de la valeur et/ou de la variation d'une impédance qui varie sous l'influence d'un champ magnétique, électrique et/ou électromagnétique, lequel est lui-même modifié par un objet se rapprochant de l'impédance, procédé dans lequel
- à chaque intervalle,
- l'impédance (Z_{X}) est soumise à une tension d'excitation sinusoïdale,
- un courant de mesure (I_{X}) est induit dans l'impédance (Z_{X}) sous l'effet de cette tension d'excitation,
- une impédance de référence (Z_{REF}) de valeur connue est soumise à une tension de compensation déphasée de 180° par rapport à la tension d'excitation, et
- un courant de compensation (I_{REF}) est induit dans l'impédance de référence (Z_{REF}) sous l'effet de la tension de compensation,
- la différence entre le courant de mesure (I_{X}) et le courant de compensation (I_{REF}), le cas échéant après une amplification, est transmise à l'entrée d'un intégrateur analogique ou numérique (42) dont la sortie, le cas échéant après une conversion numérique-analogique, fournit la valeur de la tension de compensation,
- la tension de compensation est générée, et
- la sortie de l'intégrateur (42) est le signal caractéristique de la valeur et/ou de la variation de l'impédance.

11. Procédé selon la revendication 10,
**caractérisé par** plusieurs impédances de référence (Z_{REF}) dont la valeur respective est connue, l'une de ces impédances de référence (Z_{REF}) étant soumise à la tension de compensation en fonction de la valeur de la tension de compensation, et fournissant, en conséquence, un courant de compensation (I_{REF}).

12. Procédé selon la revendication 10,
**caractérisé en ce que** la valeur de l'impédance de référence (Z_{REF}) est réglable de manière variable et est modifiée à l'aide d'un régulateur (72) qui comporte une entrée, recevant le signal à la sortie de l'intégrateur (42), et une sortie, la sortie du régulateur (72) fournissant le signal caractéristique de la valeur et/ou de la variation de l'impédance.

13. Procédé selon l'une des revendications 10 à 11,
**caractérisé en ce que** le signal différentiel, résultant de la différence entre le courant de mesure (I_{X}) et le courant de compensation (I_{REF}), le cas échéant après une amplification, est soumis à une conversion analogique-numérique, puis est transmis à un démodulateur I-Q numérique (30) dont les composantes de signal I et Q sont transmises à l'entrée d'un intégrateur numérique (42), et **en ce que**, pour constituer la tension de compensation, les composantes de signal I et Q intégrées dans le temps sont modulées dans un modulateur I-Q numérique (36) dont la sortie est reliée à un convertisseur numérique-analogique (38) qui délivre le courant de compensation analogique.

14. Procédé selon l'une des revendications 10 à 12,
**caractérisé en ce que** le signal différentiel, résultant de la différence entre le courant de mesure (I_{X}) et le courant de compensation (I_{REF}), le cas échéant après une amplification, est soumis à une conversion analogique-numérique, puis est transmis à un démodulateur I-Q numérique (30) dont les composantes de signal I et Q sont transmises à l'entrée d'un intégrateur numérique (42), et **en ce que**, pour constituer la tension de compensation, les composantes de signal I et Q intégrées dans le temps sont modulées dans un modulateur I-Q numérique (36) dont la sortie est reliée à un convertisseur numérique-analogique (38) qui délivre le courant de compensation analogique et, de plus, dans une boucle de régulation superposée avec le régulateur numérique (72), les composantes I et Q de l'impédance de référence sont ajustées en fonction de la sortie I-Q de l'intégrateur numérique (42), conformément aux consignes de régulation pour les composantes I et Q.

15. Procédé permettant de déterminer, à plusieurs intervalles et donc de manière répétée, un signal électrique caractéristique de la valeur et/ou de la variation d'une impédance qui varie sous l'influence d'un champ magnétique, électrique et/ou électromagnétique, lequel est lui-même modifié par un objet se rapprochant de l'impédance, procédé dans lequel
- à chaque intervalle,
- l'impédance (Z_{X}) est soumise à une tension d'excitation sinusoïdale, et
- un courant de mesure (_{X}x) est induit dans l'impédance (Z_{X}) sous l'effet de cette tension d'excitation,
- un courant de compensation est calculé à partir du courant de mesure (I_{X}) ou d'une grandeur qui en est dérivée, au moyen
- d'un réseau neuronal de type et de structure quelconques, et/ou
- d'un modèle de Markov caché, et/ou
- d'un réseau de Petri et/ou d'un apprentissage automatique de tout type permettant de générer des connaissances à partir du passé et d'expériences antérieures, comme par exemple l'apprentissage automatique, l'apprentissage profond, et/ou d'un traitement de prédicteurs, c'est-à-dire de variables prédictives issues d'événements enregistrés dans le passé, et
- la différence entre le courant de mesure (I_{X}) et le courant de compensation constitue le signal caractéristique de la valeur et/ou de la variation de l'impédance (Z_{X}).
